Europäisches Patentamt

(19) European Patent Office

Office européen des brevets

(11) Publication number: 0 154 078
A2

(12) # EUROPEAN PATENT APPLICATION

(21) Application number: 84307421.2

(22) Date of filing: 29.10.84

(51) Int. Cl.⁴: H 01 J 37/34

(30) Priority: 03.02.84 JP 17796/84

(43) Date of publication of application:
11.09.85 Bulletin 85/37

(84) Designated Contracting States:
DE FR GB

(71) Applicant: Kabushiki Kaisha Toshiba
72, Horikawa-cho Saiwai-ku
Kawasaki-shi Kanagawa-ken 210(JP)

(72) Inventor: Okano, Haruo c/o Patent Division
Kabushiki Kaisha Toshiba 1-1 Shibaura 1-chome
Minato-ku Tokyo(JP)

(72) Inventor: Horiike, Yasuhiro c/o Patent Division
Kabushiki Kaisha Toshiba 1-1 Shibaura 1-chome
Minato-ku Tokyo(JP)

(72) Inventor: Azukizawa, Teruo c/o Patent Division
Kabushiki Kaisha Toshiba 1-1 Shibaura 1-chome
Minato-ku Tokyo(JP)

(72) Inventor: Morishita, Mimpei c/o Patent Division
Kabushiki Kaisha Toshiba 1-1 Shibaura 1-chome
Minato-ku Tokyo(JP)

(74) Representative: Freed, Arthur Woolf et al,
MARKS & CLERK 57-60 Lincoln's Inn Fields
London WC2A 3LS(GB)

(54) Plasma treatment apparatus.

(57) A plasma treatment apparatus is disclosed in which a sample (100) is placed on a cathode (24) held in an etching chamber (34) which is filled with $CF_4$ gas with a pressure of about $10^{-2}$ torr. A high frequency voltage is applied between the cathode (24) and anode (20) to produce a plasma. A magnetic field having a component perpendicularly intersecting an electric field is generated above the cathode (24) by a magnetic field generator (60). A magnetic core (62) involved in the magnetic field generator has a combed cross section and is comprised of a plurality of coils (70). Every third coil is connected together to form three groups of coils. The three groups (72, 74, 76) of coils are respectively connected to the terminals of a 3-phase AC power source (82) having different phases. A high density plasma region is produced by a magnetic field. The electrons constituting the plasma are made to present a cycloid movement by the magnetic field, and generate a large number of ions upon collision with the molecules of $CF_4$ gas. Since the magnetic field is shifted along the surface of the cathode (24), the sample (100) set on the cathode is uniformly etched by being evenly affected by a high density plasma region.

F I G. 4

- 1 -

## Plasma treatment apparatus

This invention relates to an apparatus for plasma treatment (hereafter referred to as "a plasma treatment apparatus") applied in the manufacture of, for example, a semiconductor device, optical recording disk, etc., and more particularly, to a plasma treatment apparatus for effecting, for example, high speed etching and film formation by magnetron discharges.

In recent years, a demand has been made for the further miniaturization of a semiconductor integrated circuit. Quite recently, trial manufacturing has been done on an ultramicroscopic element having a minimum measurement of 1 to 2 microns. A reactive ion etching (RIE) method is applied in such fine work. Said RIE method generally involves the steps of introducing a reactive gas such as $CF_4$ or $CC\ell_4$ into an evacuated vessel fitted with parallel plate electrodes; supplying high frequency power between an electrode (cathode) on which a sample is placed and an anode, thereby to produce glow discharges between said cathode and anode; accelerating positive ions included in the plasma by negative D.C. self biasing occurring in the cathode (cathode dropped voltage); vertically emitting accelerated positive ions on the sample; and finally etching the sample by a physico-chemical reaction.

However, the RIE method using the above-mentioned parallel electrode plates involves the application of glow discharges having a relatively low gas-dissociating effect. When, therefore, a $SiO_2$ sample is etched by means of, for example, a reactive gas consisting of $CF_4$ and $H_2$, the rate at which said $SiO_2$ sample is etched only ranges between 300 and 400 Å/min at most. Therefore, it takes longer than several minutes to etch an $SiO_2$ layer having a thickness of 1 micron in the production of, for example, a contact hole. Consequently, a demand has been made for the acceleration of the etching speed.

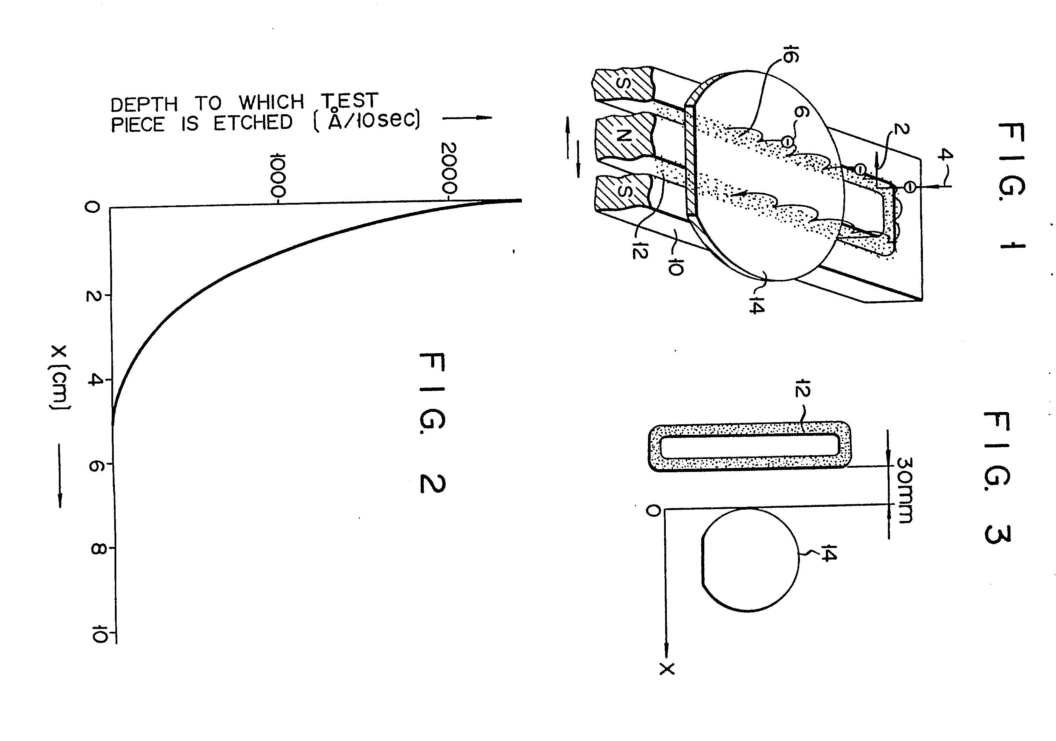

In view of the above-mentioned circumstances, the present inventors have already developed a dry etching apparatus, wherein a magnetic field-generating means, for example, a permanent magnet, is set below a cathode supplied with a high frequency power, and which effects high speed etching by magnetron discharges. (United States patent application No. 486,456). With this dry etching apparatus, a sample 14 to be etched is placed within a magnetic field (indicated by an arrow 2 given in Fig. 1) generated by a permanent magnet 10 in which an intermagnetic pole region 12 constitutes a closed loop. Electrons 6 are subjected to a cycloid movement by said magnetic field 2 and an electric field 4 perpendicularly intersecting said magnetic field 2. Thus, collisions between the electrons and the molecules of the reactive gases are noticeably accelerated to thereby generate a large amount of reactive ions. The great quantities of reactive ions are made to vertically impinge upon the sample 14, thereby effecting high speed anisotropic etching.

However, an apparatus of the above-mentioned type is accompained with the undermentioned drawbacks. Namely, while the intermagnetic pole region 12, that is, the magnetic field, remains immovable, etching takes place only in a high density magnetron discharge region 16 produced in the form of a track. Therefore, for the etching of the entire sample 14, it is necessary to scan the intermagnetic pole region 12 over a longer distance than the diameter of the sample 14. Fig. 2 is a curved diagram showing the results of measuring the rate at which the $SiO_2$ layer was etched by the reactive gas $CF_4$ (the depth attained by the 10 sec. etching) as a function of a distance measured from the edge of the sample. In the above-mentioned experiment, the intermagnetic pole region 12 remained at rest at a point 30 mm from the edge of the sample 14 (see Fig. 3). Fig. 2 shows that the 10 sec etching in the proximity of the sample edge realized etching with a depth of about 1,000 to 2,000 A, and the etching was carried out at a lower speed toward a region lying more inside the sample edge. Even if it is supposed that scanning is carried out so quickly that one reciprocation of the scanning takes only 0.05 second, the etching rate will be equivalent to the fact that the intermagnetic pole region 12 is brought to rest on both sides of the sample 14 for 2 seconds during each cycle of about 80 scanning reciprocations. In this case, the sample edge is etched with a depth of about 500 A. Such speedy etching of the peripheral portions of the sample will reduce the uniformity of the etching of the whole sample. It may be contemplated to broaden the intermagnetic pole region 12 as a means for preventing the occurrence of such an objectionable event. If X (Fig. 2) measures 50 mm, the sample will not be etched, even when the intermagnetic pole region 12 stands at rest. If, therefore, the intermagnetic pole region 12 is scanned at a distance of 80 mm from the sample, then the sample can be uniformly etched. However, such an attempt will be accompained with the drawbacks that the plasma treatment apparatus will grow large, the etching rate will be reduced, and consequently, it will be difficult to treat the sample with plasma when the diameter of the sample becomes large (over 6 inches).

The above-mentioned problems are encountered not only in the etching operation, but also in the deposition of a film by means of plasma CVD or sputtering. Now let it be assumed that a film is sputtered by parallel electrode plates with a sample target set on the cathode and a wafer to be covered with a film placed on the anode. If, in such a case, the target set on the cathode is not uniformly etched, a film will fail to be uniformly deposited on the sample, and the effective life of the target will be shortened.

This invention has been accomplished in view of the above-mentioned circumstances and is intended to provide a plasma treatment apparatus capable of uniformly treating a sample at a high speed without being enlarged in size. Another object of the invention is to provide a dry etching apparatus capable of uniformly etching a sample at a high speed. Still another object of the invention is to provide a vapor phase growth apparatus or sputtering apparatus capable of depositing a film on a sample with a uniform thickness. Still another object of the invention is to provide a plasma treatment apparatus capable of treating a sample with a large diameter.

To attain the above-mentioned objects, this invention provides a plasma treatment apparatus capable of treating a sample by ionizing an excited gas which comprises a housing having a chamber therein, an anode and a cathode which faces said anode. A sample to be treated is set between the cathode and anode or on the cathode or anode or at a point removed therefrom. A gas to be activated is introduced from a gas source into said chamber. A high frequency power source applies a high frequency voltage between the cathode and anode to generate an electric field, thereby producing a plasma.

A magnetic field-generating means which involves a magnetic core consisting of a plurality of magnetic pole sections arranged in a first direction which is along the surface of the cathode, a plurality of coils provided to the magnetic core and respectively generating a magnetic field which has a component perpendicularly intersecting the electric field, and means for supplying alternative currents having different phases through said coils.

The plasma treatment apparatus embodying this invention offers the advantages that a high density plasma region is always scanned in a direction by the magnetic field-generating means constituted by the magnetic core and a plurality of coils; therefore, a sample set on the cathode can be entirely ethced at a high speed. The drawback is eliminated in that the peripheral portions of a sample are etched at a particularly high speed as has been observed in the case where the intermagnetic pole region is subjected to reciprocating scanning in the conventional plasma treatment apparatus; therefore, the entire sample is always uniformly etched. Also, a film can be deposited by vapor growth on a sample set on the cathode with a uniform thickness. When a sample to be covered with a film is placed on the anode, a target set on the cathode can be uniformly etched at a high speed; therefore, a film can be deposited on the sample uniformly and at a high speed. Since a high density plasma is electrically scanned, in other words, a magnetic field can be continuously shifted in one direction with the magnetic field-generating means kept immovable, the subject plasma treatment apparatus can be miniaturized. For the reason given above, it is unnecessary to provide mechanically movable members, and the subject plasma treatment apparatus is noticeably improved in reliability, and therefore, is well adapted for the manufacturing of, for example, a semiconductor device, optical recording disc, etc., and further can be easily applied in treating a large diameter sample.

This invention can be more fully understood from the following detailed description when taken in conjunction with the accompanying drawings, in which:

Fig. 1 is an oblique view showing the concept on which the conventional dry etching device is based;

Fig. 2 graphically sets forth the relationship between the etching depth and a distance extending from the intermagnetic pole region to the sample;

Fig. 3 shows the condition under which the data of Fig. 2 were measured;

Fig. 4 is a cross sectional view of an entire dry etching apparatus according to a first embodiment of this invention;

Fig. 5 is an oblique view of a magnetic core involved in said dry etching apparatus;

Fig. 6 indicates the relative positions of the magnetic pole sections and the coils constituting said magnetic core;

Figs. 7(A) and 7(B) illustrate the operations of the members of Fig. 6;

Fig. 8 is a cross sectional view of the proximity of the magnetic core involved in a dry etching apparatus according to a second embodiment of the invention;

Fig. 9 is a cross sectional view of a dry etching apparatus according to a third embodiment of the invention;

Fig. 10 is a cross sectional view of a dry etching apparatus according to a fourth embodiment of the invention; and

Fig. 11 is a plan view of a cathode involved in a dry etching apparatus according to a fifth embodiment of the invention.

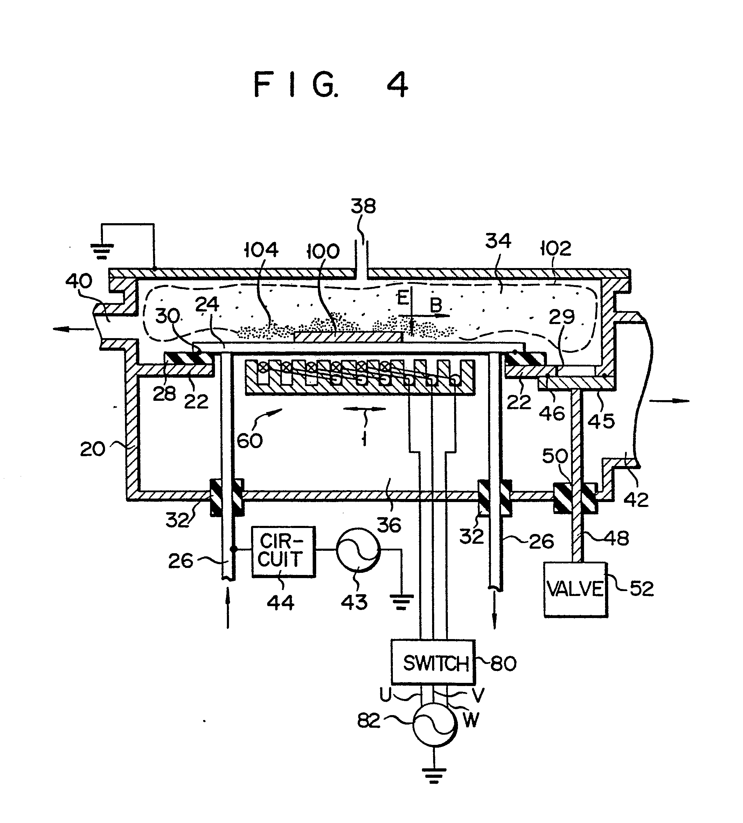

Fig. 4 shows a dry etching apparatus according to a first embodiment of this invention. A housing 20 is grounded. The interior of the housing 20 is divided into an etching chamber 34 and a magnetic field-generating chamber 36. It is preferred that a pressure prevailing in the interior of said chamber 36 be made lower than the atmospheric pressure to suppress the occurrence of discharges in said chamber 36. Sandwiched between the cathode 24 and the wall 22 of the housing 20 is an insulation member 28 prepared from an insulating material such as fluorine-containing resin. The cathode 24 is insulated from the housing 20. An O-ring 30 is interposed between the cathode 24 and insulation material 28, thereby shutting a space between the etching chamber 34 and magnetic field-generating chamber 36 in a gas-tight fashion. A cooling water duct is formed in the cathode 24. This duct is connected to an external cooling water source through a pipe 26 prepared from a conductive material. Interposed between said pipe 26 and housing 20 is an insulating member 32 prepared from the same insulation material as that of the insulation member 28 to ensure insulation between the pipe 26 and housing 20. Connected to said pipe 26 is a high frequency power source 43 through a matching circuit 44, thereby allowing for the conduction of power to the cathode 24. The upper wall of the housing 20 faces the cathode 24 in a parallel relationship, and functions as an anode.

The housing 20 is provided with a port 38 through which $CF_4$ gas is brought into the etching chamber 34. When excited, said $CF_4$ gas generates reactive ions. The housing 20 is provided with an exhaust port 40 connected to an evacuation device such as a vacuum pump in order to evacuate the interior of the etching chamber 34.

Installed in the magnetic field-generating chamber 36 below the cathode 24 is a magnetic field generator 60 which produces a movable magnetic field. The housing 20 is further provided with an exhaust port 42 connected to an evacuation device such as a vacuum pump in order to evacuate the interior of the magnetic field-generating chamber 36. The vacuum pump maintains the interior of said magnetic field-generating chamber 36 at a vacuum of about $10^{-4}$ torr. The intermediate wall 22 of the housing 20 is provided with a ventilation port 29. A partition valve 45 fitted to the underside of the intermediate wall 22 to cover the ventilation port 29 is connected to an electromagnetic valve 52 by means of a support rod 48. This support rod 48 is insulated from the housing 20 by an insulating material 50. The partition valve 45 opens or closes the ventilation port 29, depending on the operation of the electromagnetic valve 52. An O-ring 46 is fitted to the underside of the wall 22 around the ventilation port 29. When the partition valve 46 is pressed against the underside of the wall 22, the etching chamber 34 and magnetic field-generating chamber 36 are separated from each other in a gas-tight fashion.

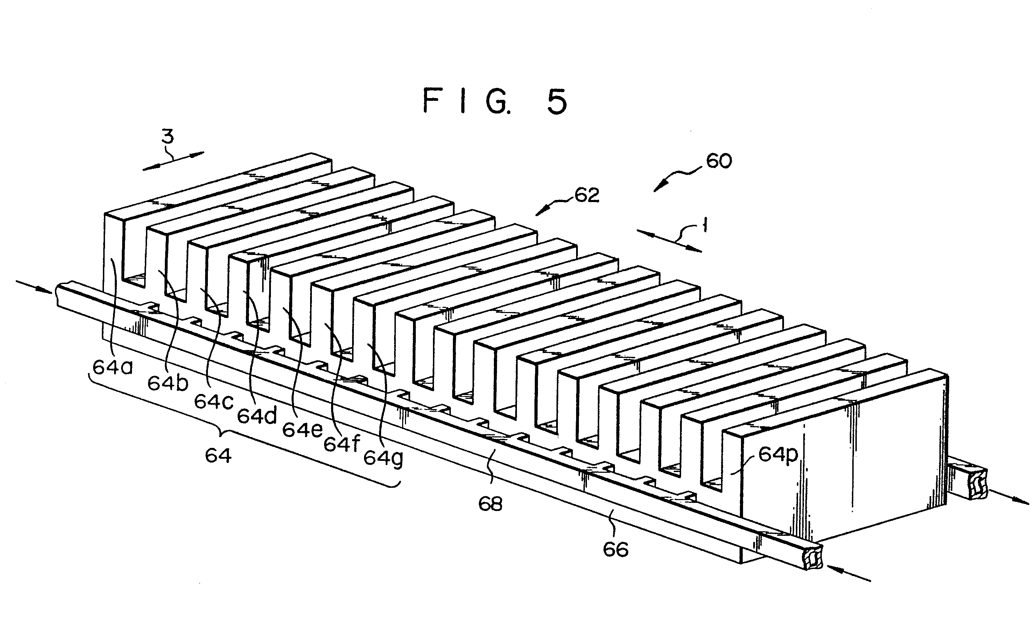

A description may now be made of the magnetic field generator 60 with reference Figs. 5, 6 and 7.

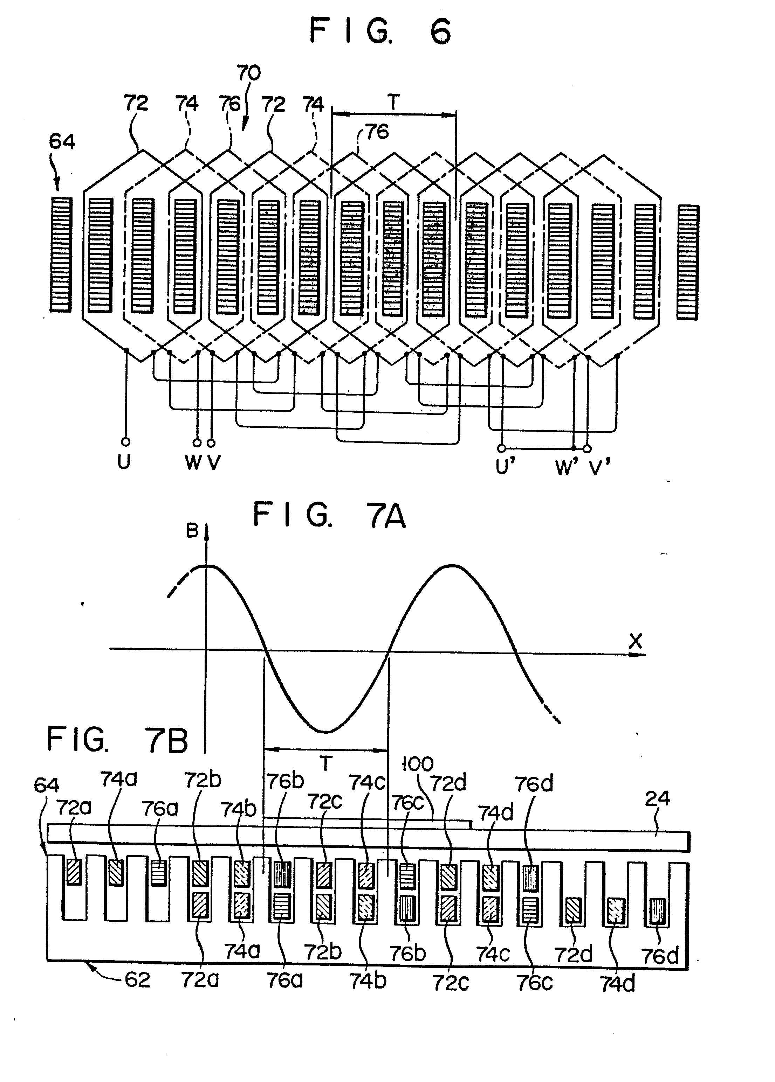

Fig. 5 is an oblique view of the magnetic core 62. Fig. 6 shows the relative positions of the magnetic pole sections 64 constituting said magnetic core 62 and the coils. Fig. 7(b) is a sectional view of the magnetic core 62 in its lengthwise direction (indicated by an arrow 1 in Fig. 5). The magnetic generator 60 comprises the magnetic core 62 and a group 70 of coils (Fig. 6). The magnetic core 62 is constituted by a flat base 66 and a plurality of (16 indicated) parallel magnetic pole plates (64a ... 64p) integrally erected on said base 66. Therefore, the longitudinal section of the magnetic core 62 presents a comb pattern. This comb-shaped magnetic core 62 can be fabricated by cutting out parallel grooves across a flat magnetic block. The width (indicated by arrow 2 in Fig. 5) of the magnetic pole sections 64 is longer than the diameter of a sample 100 (shaped like, for example, a disc) set on the cathode 24. The length (indicated by an arrow 1 in Fig. 5) of the base 66 is longer than the diameter of said sample 100.

A cooling water duct is formed in the magnetic core 62. This duct communicates a pipe 68 connected to a cooling water source (not shown). The cooling water runs through said pipe 68 into the magnetic core 62 for cooling. The pipe 68 (not shown in Fig. 4) extends to the outside, while being insulated from the housing 20.

Referring to Fig. 6, the magnetic coil group 70 comprises four coils 72a, 72b, 72c and 72d (coils 72) shown in solid lines, four coils 74a, 74b, 74c and 74d (coils 74) indicated in broken lines, and four coils 76a, 76b, 76c and 76d (coils 76) set forth in dot-dash lines. The coil 72a surrounds the whole block of the magnetic pole sections 64b, 64c and 64d several times. Therefore, the conductor of said coil 72a lies between the magnetic pole sections 64a and 64b and also between the magnetic pole sections 64d and 64e. The coil 74a surrounds the whole block of the magnetic pole sections 64c, 64d and 64e several times. Therefore, the conductor of said coil 74a lies between the magnetic pole sections 64b and 64c and also between the magnetic pole sections 64e and 64f. The other coils 76a, 72b, 74b, 76b ... respectively surround the whole block of the corresponding three magnetic pole sections. Thus the conductors of said other coils 76a, 72b, 74b, 76b ... lie between the adjacent pole sections. The coils 72a, 72b, 72c and 72d are connected to each other. Similarly, the coils 74a, 74b, 74c and 74d are connected to each other. The coils 76a, 76b, 76c and 76d are also connected to each other. The coil groups 72, 74 and 76 are connected to a 3-phase A.C. source 82 through a switch 80 (Fig. 4). The coils 72, 74 and 76 are respectively supplied with AC currents having different phases. The switch 80 effects changeover between the connections of the U, V and W terminals of the 3-phase AC source 82 to the coils 72, 74 and 76. In other words, the connections of the coils 72, 74 and 76 to said power source 82 are changed over between the case where the coils 72, 74 and 76 are applied with progressively higher voltages in the order mentioned and the case where the coils 76, 74 and 72 are applied with progressively higher voltages in the order mentioned.

When 3-phase AC currents having phases differentiated from each other by 120 degress run through the coils 72, 74 and 76, then a magnetic flux density B, as shown in Fig. 7(a), arises on the cathode 24. This magnetic flux density is expressed by the following equation:

$$B = B_o \cos(\omega t - \pi x/\tau) \qquad \ldots\ldots (1),$$

where:

$\omega$ = the angular frequency of the 3-phase AC source [rad/sec] ($\omega = 2\pi f$, f: frequency [Hz])

t = time [sec]

x = distance [mm] from a reference point on the surface of a magnetic core

$\tau$ = pole pitch [mm]

The pole pitch is herein defined to mean a half wavelength, the form in which the magnetic flux density distirubiton varies, namely, the length of half the period during which the magnetic flux varies. Fig. 7A shows the distribution of a magnetic flux density B at an intial point of time (t = 0). The magnetic flux B given in the previously mentioned equation 1 shows that a magnetic field having a magnetic flux density distribution shown in Fig. 7A is progressively shifted with time $\tau$ to the right of Figs. 7A and 7B. On the cathode 24, therefore, the high and low levels of a magnetic field, acting lengthwise (in the direction of arrow 1 given in Fig. 4) of the magnetic field generator 60, appear alternately. The generation of the above-mentioned magnetic field leads to the production of a high density plasma region on the cathode 24. The movement of said magnetic field causes said plasma region to be continuously shifted in the direction of arrow 1.

A description may now be made of the operation of a dry etching apparatus embodying this invention which is arranged as described above. Let it be assumed that a sample 100 is placed on the cathode 24. The partition valve 45 is opened to effect communication between the etching chamber 34 and magnetic field-generating chamber 36. The interior of the housing 20 is evacuated through the exhaust ports 40 and 42. Then, the partition valve 45 is closed, and the interior of the magnetic field-generating chamber 36 is evacuated by a vacuum pump to hold the vacuum of said interior at a level of $10^{-4}$ torr, thereby preventing the occurrence of discharges in the magnetic field generator 60. While the etching chamber 34 is evacuated by vacuum pump. $CF_4$ gas is taken into the etching chamber 34 through the gas inlet port 38 to fill said chamber 34 with $CF_4$ gas having a pressure of $10^{-2}$ torr. While the above-mentioned condition is preserved, high frequency voltage (13.56 MHz) is impressed on the cathode 24 from the high frequency power source 43. At this time, an electric field E is generated between the cathode 24 and the anode (constituted by the upper wall of the etching chamber 34), thereby giving rise to glow discharges and a low density plasma region 102. When a 3-phase AC current is supplied from the power source 82 to the coil 70 simultaneously with the above-mentioned voltage impression between the cathode 24 and anode, then a magnetic field B, atcing lengthwise of the magnetic field generator 60 (having a component perpendicularly intersecting the magnetic field E), is produced on the sample 100 placed on the cathode 24. The action of the perpendicularly intersecting electric field E and magnetic field B gives rise to high, medium and low magnetron discharges whose phases are displaced from each other. When, therefore, receiving an electromagnetic force acting in the direction E × B, electrons start a cycloid motion. The electrons frequently collide with the molecules of the $CF_4$ gas, causing a high density plasma region 104 to be generated between the magnetic poles. This high density plasma region 104 moves with the magnetic field B which is shifted lengthwise of the magnetic field generator 60 (in the direction of arrow 1 given in Fig. 4). Therefore, the result of integrating the periods during which the sample 100 is affected by the high density plasma region 104 remains uniform throughout the entire sample 100, thereby ensuring its uniform and quick etching. When the operation of the switch 80 is changed over, the magnetic field B and the high density plasma region 104 are moved in the opposite direction. When, therefore, the movement of said magnetic field B and high density plasma region 104 is reversed during the prescribed etching period, a more uniform etching can be ensured.

The dry etching apparatus embodying this invention offers the advantages that the sample 100 can be etched quickly and uniformly by the action of the magnetic field generator 60. This magnetic field generator 60 may have a size slightly lower than the sample 100, making it unnecessary to apply a large size plasma treatment apparatus. The omission of mechanically movable parts improves the reliable operation of the subjected plasma treatment apparatus and also ensures its miniaturization. Since the sample 100 is always exposed to the high density plasma region 104, an etching rate is decreased very little even when said sample happens to have a large diameter. Therefore, etching can be carried out at the same rate (about 5 microns/min) as when the intermagnetic pole region is brought to rest.

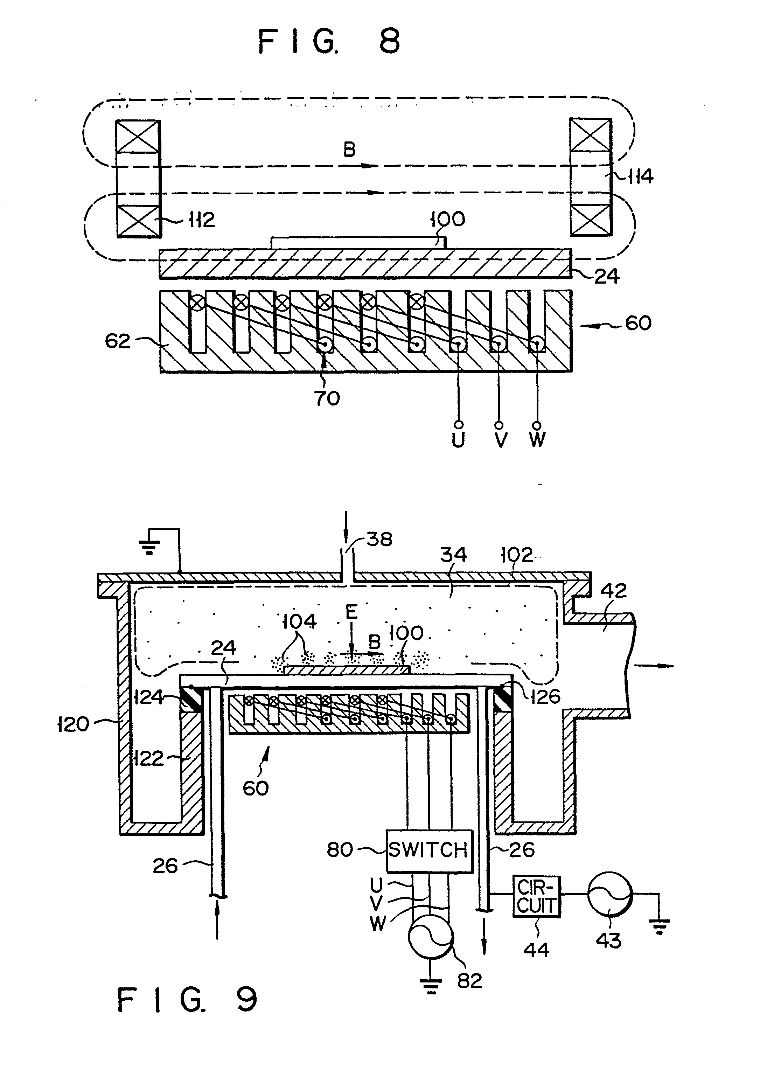

A description may now be made with reference to Fig. 8 of a dry etching apparatus according to a second embodiment of this invention. This second embodiment is different from the first embodiment in that Helmholtz coils 112 and 114 are provided on the cathode 24. In other respects, the second embodiment is exactly the same as the first embodiment.

When, with the second embodiment arranged as described above, an electric current is conducted through the Helmholtz coils 112 and 114, a stronger magnetic field can be produced on the sample 100.

- 14 -

0154078

This event offers the advantages that a horizontal
magnetic field produced on the sample 100 is more
enlarged, thereby ensuring a noticeable reduction
in the ion-accelerating voltage and, consequently,
in radiation damage (refer to Y. Horiike, and H. Okano;
Jpn, J. Appl phys. 20, 1981, L 817).

A description may now be made with reference to
Fig. 9 of a dry etching apparatus according to a third
embodiment of this invention. The same parts of Fig. 9
as those of Fig. 4 are denoted by the same numerals,
a description thereof being omitted. The third
embodiment of Fig. 9 is different from the first
embodiment in that the magnetic field generator
60 is set in the atmosphere. Namely, the cathode
24 is fixed on the upper end of the upright wall
122 of the housing with an insulation material 124
interposed therebetween. An O-ring is provided
between the cathode 24 and the upright wall 122.
A plasma treatment apparatus embodying this
invention, which involves the magnetic field
generator 60, offers the advantages that etching
is carried out at a prominently larger rate than
in the conventional apparatus, even when the
intensity of a magnetic field generated in the
intermagnetic pole region and the magnitude of
a high frequency power are reduced, the cathode
24 can be made sufficiently thick (more than 10 mm),
and the magnetic field generator 60 is substantially
saved from the occurrence of discharges, even if
the highly evacuated chamber 36 is not provided
to hold a magnetic field generator. Therefore,
the third embodiment of Fig. 9 offers the advantages
that the same effect as in the preceding embodiment
is ensured, and the subject plasma treatment apparatus
can be simplified in its arrangement.

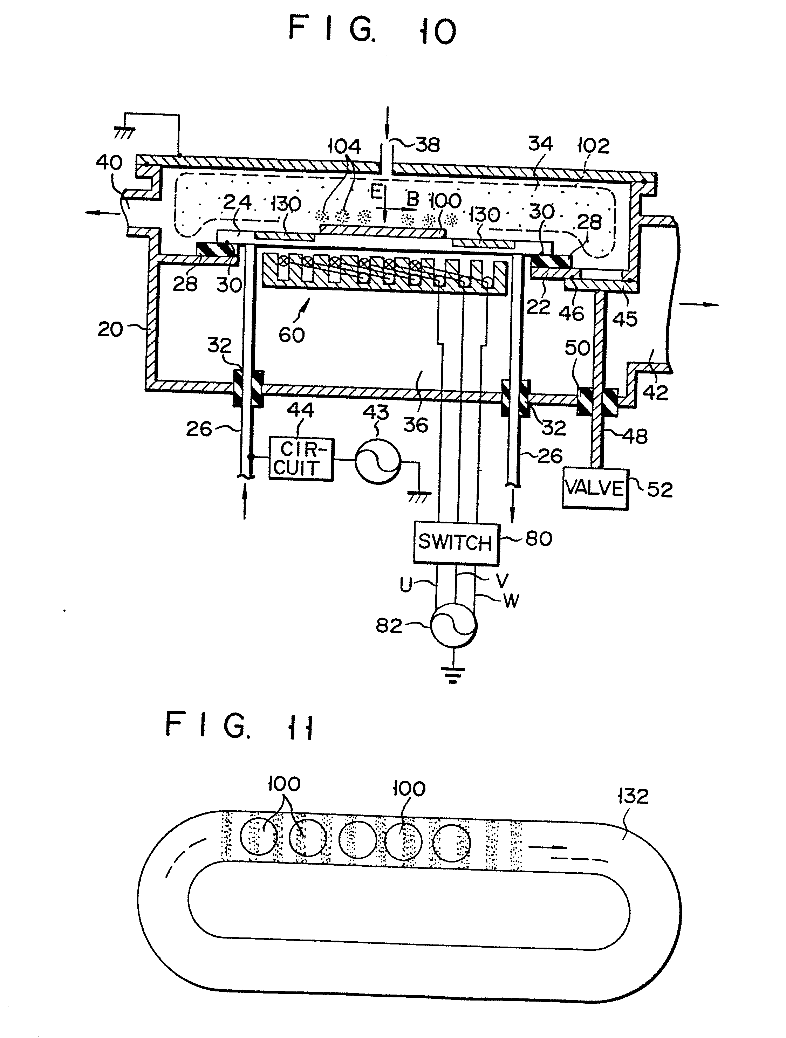

A description may now be made with reference
to Fig. 10 of a dry etching apparatus according to a fourth embodiment of this invention. The same parts of Fig. 10 as those of Fig. 4 are denoted by the same numerals, a description thereof being omitted. The fourth embodiment is different from the first embodiment in that magnetic members 130 (for example, an iron plate) are embedded in that portion of the surface of the cathode 24 which faces the etching chamber 34. Namely, on the surface of the cathode 24, magnetic members 130 are embedded ahead and behind the region on which the sample 100 is placed, as viewed from the direction in which the magnetic field is scanned. The fourth embodiment of Fig. 10 offers the advantages that even when the end of the magnetic field generator 60 lies under the magnetic member 130, the greater part of the magnetic flux passes through the highly permeable magnetic member 130, thereby suppressing the generation of a magnetic field above said magnetic member 130; therefore, the high density plasma region 104 surrounding the sample 100 is eliminated, a magnetic field can take a more uniform action in its prescribed moving direction, and etching can be carried out at a more uniform rate.

It will be noted that this invention is not limited to the foregoing embodiments. For instance, the aforementioned magnetic field generator need not comprise a 3-phase winding type coil. Namely, the coil may be changed, for example, into a 2-phase winding type. The magnetic field generator well serves the purpose, provided said generator consists of a magnetic core and a plurality of coils and is so arranged that a magnetic field generated on the cathode can be continuously shifted in one direction. The size of the grooves formed in the magnetic core and the intervening space can be properly changed, depending on the manner on which the subject dry etching apparatus is applied. It is also possible to etch a plurality of samples 100 at the same time by constructing the cathode 132 in the form of a track, as shown in Fig. 11, and appylying a magnetic field generator similarly shaped like a track. This arrangement elevates the capacity of the dry etching apparatus. The subject dry etching apparatus is applicable to the etching of not only a $SiO_2$ layer but also any other film.

The subject plasma treatment apparatus is applicable not only to etching but also the deposition of a layer by means of plasma CVD or sputtering, or ashing treatment. In the case of sputtering, it is necessary to set a target on the cathode and place a sample to be covered with a film on the anode. In this case, the target can be etched quickly and uniformly as is the aformentioned sample to be etched. Therefore, a film can be quickly deposited on the sample with a uniform thickness. Further, as in the case of etching, a magnetic field can be shifted in the direction with the magnetic field generator kept immovable. Therefore, the subject sputtering apparatus can be miniaturized and improved in reliability due to the omission of the mechanical movable parts, as in the case of etching apparatus. The kind of gas to be activated which is introduced into a plasma treatment chamber may be properly selected, depending on the kind of a sample placed on the cathode for etching, a sample to be covered with a film or a target applied. The present invention can be practiced with various changes and modification, without departing from the object of the invention.

Claims:

1.  A plasma treatment apparatus for treating a sample by ionizing an excited gas which comprises:
       a housing (20, 120) having a chamber (34) therein;
       an anode (20, 120);
       a cathode (24, 132) which faces said anode in said chamber with the sample (100) placed between said cathode and anode;
       means (38) for introducing a gas to be activated in the chamber (34);
       means (43) for impressing a high frequency power between said anode and cathode to generate an electric field therebetween for producing a plasma;
       characterized by further comprising
       magnetic field-generating means (60) for providing a magnetic field movable on the sample (100), said magnetic field-generating means (60) being comprised of a magnetic core (62) involving a plurality of magnetic pole sections (64) arranged in a first direction (1) which is along the surface of the cathode, a plurality of coils (70) provided to the magnetic core to generate on the sample a magnetic field having a component perpendicularly intersecting said electric field, and means (82) for supplying said coils with alternative currents having different phases.

2.  The plasma treatment apparatus according to claim 1, characterized in that said magnetic core (62) comprises a base (66), the magnetic pole sections (64) are spatially erected on said base, and the section of said magnetic core which extends in the first direction presents a combed pattern.

3.  The plasma treatment apparatus according to claim 2, characterized in that the coils (70) are so wound as to surround three magnetic poles, every third coil is connected together to form first (72), second (74) and third (76) groups, the AC supplying means (82) is of the 3-phase type, and the first, second and third groups of coils are respectively connected to the corresponding different phases of said 3-phase AC source.

4. The plasma treatment apparatus according to claim 3, characterized by comprising a switch (80) connected between the first (72), second (74) and third (76) groups of coils and AC supplying means to change the phase of the current supplied to said first, second and third groups of coils.

5. The plasma treatment apparatus according to claim 4, characterized in that that portion of the magnetic core which extends in the first direction (1) and that section of said magnetic core which extends in a second direction (3) perpendicularly intersecting said first direction have a greater length than the sample (100).

6. The plasma treatment apparatus according to claim 5, characterized in that said housing (20) comprises a magnetic field-generating chamber (36) separated from said chamber (34), and said magnetic field-generating means (60) is set in said magnetic field generating chamber.

7. The plasma treatment apparatus according to claim 5, characterized in that said magnetic field generating means (60) is evacuated to a pressure which is not higher than the atmospheric level.

8. The plasma treatment apparatus according to claim 5, characterized by comprising Helmholtz type coils (112, 114) provided near the cathode (24) to generate a magnetic field extending in parallel with the surface of the cathode.

9. The plasma treatment apparatus according to claim 5, characterized by comprising magnetic members (130) embedded ahead and behind of the sample (100) as viewed from the first direction (1) in which said sample is set.

10. The plasma treatment apparatus according to claim 5, characterized in that the cathode (132) and the magnetic core base respectively have an endless pattern, and a plurality of samples (100) are placed on said endless-shaped cathode.

11. The plasma treatment apparatus according to claim 1, characterized in that an excited gas produces ions, and said ions etch the sample (100) placed on the cathode (24).

12. The plasma treatment apparatus according to claim 1, characterized in that a film is formed on the surface of the sample (100) by the vapor growth of said excited gas.

13. The plasma treatment apparatus according to claim 1, characterized in that ions are sputtered on the target placed on the cathode (24), thereby causing the target-constituting material to be released on the sample (100) set on the anode (20).

# FIG. 1

# FIG. 3

30mm

# FIG. 2

0154078

F I G. 4

F I G. 5

0154078

F I G. 6

F I G. 7A

F I G. 7B

0154078

# FIG. 8

# FIG. 9

0154078

FIG. 10

FIG. 11